# EUROPEAN PATENT SPECIFICATION

(11) **EP 3 304 205 B1**
(45) Date of publication and mention of the grant of the patent: **10.04.2019**
(21) Application number: 16722836.0
(22) Date of filing: 04.05.2016
(51) Int. Cl.: G03F 7/20, G01L 1/24, G01B 11/16

(54) **MONITORING APPARATUS, LITHOGRAPHIC APPARATUS AND METHOD OF MONITORING A CHANGE IN A PROPERTY**
ÜBERWACHUNGSVORRICHTUNG, LITHOGRAFISCHE VORRICHTUNG UND VERFAHREN ZUR ÜBERWACHUNG EINER VERÄNDERUNG EINER EIGENSCHAFT
APPAREIL DE SURVEILLANCE, APPAREIL LITHOGRAPHIQUE ET PROCÉDÉ DE SURVEILLANCE DE CHANGEMENT D'UNE PROPRIÉTÉ

(30) Priority: 02.06.2015 EP 15170184
(43) Date of publication of application: 11.04.2018
(73) Proprietor: ASML Netherlands B.V., 5500 AH Veldhoven (NL)
(72) Inventor: LEIJTENS, Johannes, Adrianus, Petrus, 5500 AH Veldhoven (NL); AKKERMANS, Johannes, Antonius, Gerardus, 5500 AH Veldhoven (NL); HAVERDINGS, Michael, Benjamin, 5500 AH Veldhoven (NL); KAT, Pieter, Lucas, 5500 AH Veldhoven (NL); LEENKNEGT, George, Alois, Leonie, 5500 AH Veldhoven (NL)
(74) Representative: Ras, Michael Adrianus Josephus
(86) International application number: PCT/EP2016/060002
(87) International publication number: WO 2016/192918

(56) References cited:
- US-A1- 2004 104 337
- US-A1- 2012 249 987
- US-A1- 2015 144 773

## Description

### FIELD

The present invention relates to a monitoring apparatus and method, and to a lithographic apparatus comprising such a monitoring apparatus.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Lithographic apparatuses comprise one or more monitoring apparatuses for monitoring the strain or temperature of components of the lithographic apparatus, or objects conveyed by the lithographic apparatus. Such monitoring apparatuses may form part of deformation sensors for measuring deformation of components of the lithographic apparatus, or objects conveyed by the lithographic apparatus. Such monitoring apparatuses often use fiber-Bragg grating sensors, wherein a change in the Bragg wavelength of a fiber-Bragg grating within the fiber-Bragg grating sensor indicates a change in the property (e.g. strain or temperature) being measured. Such fiber-Bragg grating based sensors often use interferometry techniques to measure the change in the Bragg wavelength. However, such interferometry techniques are susceptible to temperature variations and refractive index changes in the interferometer apparatus.

### SUMMARY

It is desirable to improve upon monitoring apparatuses comprising fiber-Bragg grating based sensors and which use interferometry techniques.

According to an aspect of the invention, there is provided a monitoring apparatus configured to monitor a change in a property, comprising:
a fiber-Bragg grating sensor operable to sense a band of wavelengths of incident radiation and to output a corresponding sensor output signal, the band of radiation being centered upon a first value representing a Bragg wavelength of the fiber-Bragg grating sensor;
an amplifier arranged to separate the sensor output signal in a first part and a second part, to create an inverted first part by inverting the first part, and to create an amplified signal based on the inverted first part and the second part;
an integrator operable to integrate the amplified signal to obtain an integrated signal; and
a processor operable to:
   derive a second value representative of a shift of the Bragg wavelength based on the integrated signal; and
   derive a change in the monitored property from the second value.

According to a further aspect of the invention, there is provided a method of monitoring a change in a property, comprising:
using a fiber-Bragg grating sensor to sense a band of wavelengths of incident radiation and to output a corresponding sensor output signal, said band of radiation being centered upon a first value representing a Bragg wavelength of the fiber-Bragg grating sensor;
separating the sensor output signal in a first part and a second part;
creating an inverted first part by inverting the first part;
creating an amplified signal based on the inverted first part and the second part;
integrating the amplified signal to obtain an integrated signal;
deriving a second value representative of a shift of the Bragg wavelength based on the integrated signal; and
deriving a change in the monitored property from the second value.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 is a graph showing reflectivity on the y-axis against wavelength λ on the x axis for a pi-shifted fiber-Bragg grating sensor;
- Figure 3 shows schematically a monitoring apparatus according to an embodiment of the invention;
- Figure 4a shows graphs of spectra and signal variation with time at a number of locations of the monitoring apparatus illustrated in Figure 3, for the situation where the laser output center wavelength is correctly tuned to the Bragg wavelength of the fiber-Bragg grating sensor; and
- Figure 4b shows graphs of spectra and signal variation with time at a number of locations of the circuit illustrated in Figure 3, for the situation where the laser output center wavelength is not correctly tuned to the Bragg wavelength of the fiber-Bragg grating sensor.

### DETAILED DESCRIPTION

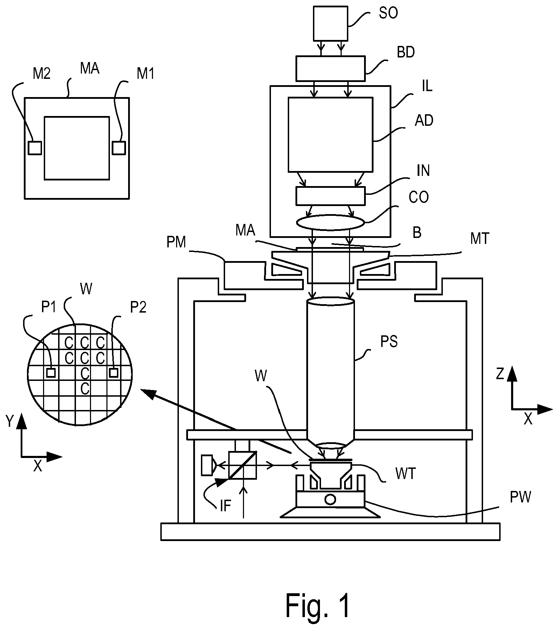

Figure 1 schematically depicts a lithographic apparatus according to one embodiment of the invention. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The support structure MT supports, i.e. bears the weight of, the patterning device MA. It holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion C of the substrate W. It should be noted that the pattern imparted to the radiation beam may not exactly correspond to the desired pattern in the target portion C of the substrate, for example if the pattern includes phase-shifting features or so called assist features. Generally, the pattern imparted to the radiation beam will correspond to a particular functional layer in a device being created in the target portion C, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such a machine having multiple stages, the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the radiation source SO to the illuminator IL with the aid of a beam delivery system BD comprising, for example, suitable directing mirrors and/or a beam expander. In other cases the radiation source SO may be an integral part of the lithographic apparatus, for example when the radiation source SO is a mercury lamp. The radiation source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device MA, which is held on the support structure MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using mask alignment marks M1, M2 and substrate alignment marks PI, P2. Although the substrate alignment marks PI, P2, as illustrated occupy dedicated target portions, they may be located in spaces between target portions C (these are known as scribe-lane alignment marks). Similarly, in situations in which more than one die is provided on the patterning device MA, the mask alignment marks M1, M2 may be located between the dies.

The depicted apparatus could be used in at least one of the following modes:
1. In step mode, the patterning device MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the patterning device MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the patterning device MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

The lithographic apparatus may comprise one or more monitoring apparatuses for monitoring a property. The property being monitored may be the strain and/or temperature of any component of the lithographic apparatus, for example the substrate table WT or support structure MT. Monitoring apparatuses may also be used for monitoring strain and/or temperature of any object conveyed by the lithographic apparatus, for example the substrate W or patterning device MA.

Deformation of the component or object can then be determined based upon the strain or temperature measurements. Such monitoring apparatuses may comprise fiber-Bragg grating sensors (FBG sensors), which in turn may comprise a fiber-Bragg grating (FBG). United States Patent Application No. US2012/0249987 describes a deformation sensor comprising an FBG sensor. While FBG sensors are often employed to sense strain or temperature, monitoring devices disclosed herein may monitor properties other than strain and/or temperature. This may be achieved by adding receptors to the monitoring apparatus for example.

FBG sensors are devices which comprise a segment of optical fiber, the optical fiber comprising an optical fiber core which has a periodic variation in its refractive index, this periodic variation being otherwise referred to as a fiber-Bragg grating, or Bragg grating. One type of FBG sensor reflects a particular narrow band of wavelengths and transmits all other wavelengths (or at least a wide range of wavelengths). Another type of FBG sensor, known as a pi-shifted FBG sensor (πFBG sensor) has this response reversed, so that only a narrow band of wavelengths is transmitted. The concepts described herein are equally applicable to either type of FBG sensor. Return reflection radiation from a standard FBG and transmission radiation from a πFBG will give an approximately similar intensity profile on the detector. It is this profile which is important. In either case the narrow reflection/transmission band is centered upon a wavelength known as the Bragg wavelength. The Bragg wavelength is dependent upon the strain applied to the FBG sensor and to the temperature of the FBG sensor. By monitoring changes in the spectral position of the Bragg wavelength, changes in strain or temperature can be monitored.

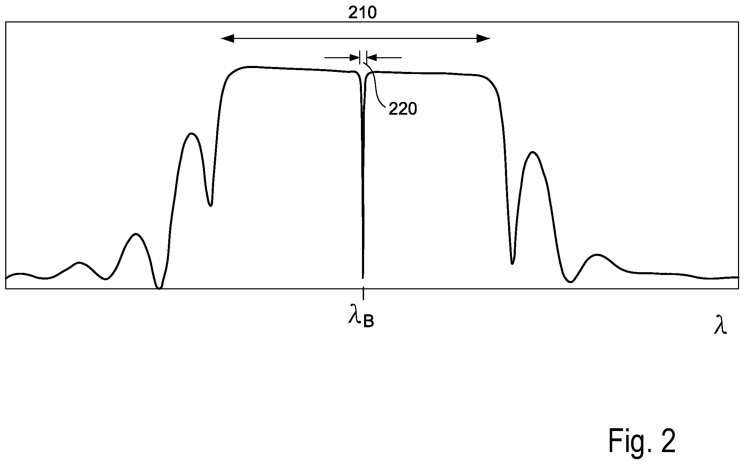

Figure 2 is a graph showing reflectivity on the y-axis against wavelength λ on the x axis for a πFBG sensor. It can be seen that there is a wide range of reflected wavelengths 210. Within the wide range of reflected wavelengths 210 is a narrow transmission band 220 of wavelengths which are transmitted. The center (transmission peak) of this narrow transmission band 220 is the Bragg wavelength λ_{B}.

The highest accuracy FBG sensors known use interferometric measurements to determine the average Bragg wavelength shift. Such devices may use Mach Zehnder Interferometers (MZIs) to determine the wavelength shift. However, MZIs are sensitive to temperature variations due to the extreme sensitivities of the delay coil in the interferometer, and to the refractive index change of the waveguide material used. As a consequence the optical path difference of the MZI has to be determined as accurately as possible, and compensated for, in order to obtain the maximum performance. This can be done by adding a reference laser to measure the actual optical path difference or by measuring the temperature up to the micro Kelvin level and calculating the theoretical optical path length change as a function of the temperature change. Both methods add significant costs and complexity to the measurement setup.

It is therefore proposed not to use interferometric measurements at all. It is proposed instead to impart laser radiation on the FBG sensor, the laser output being controlled to scan through a scanning band, such that its wavelength scans through the narrow transmission band of the FBG sensor (which includes the Bragg wavelength). The resultant signal is then integrated using a positive sign for half of the scan range and a negative sign for the other half of the scan range. The integrated signal provides an offset from which any shift in the Bragg wavelength can be calculated. A control voltage can also be derived from the integrated signal, for controlling the average current through the laser such that it is tuned to the weighted average of the FBG sensor's response.

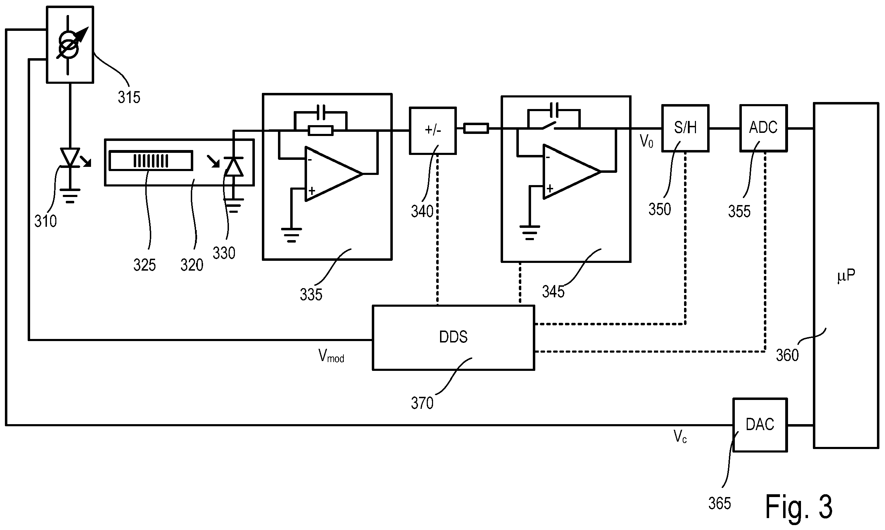

Figure 3 shows a circuit arrangement of a monitoring apparatus according to an embodiment of the invention. It shows a radiation source, in this example a laser 310, powered by (e.g. DC) current source 315. An FBG sensor 320 comprises FBG 325 and a radiation sensor 330. Based on the band of wavelengths of incident radiation provided by the laser 310, the radiation sensor 330 provides a sensor output signal. The sensor output signal of the radiation sensor 330 is converted to a voltage by transimpedance amplifier 335 and fed into amplifier 340 which is controlled to selectively have a gain of either +1 or -1. The output of amplifier 340 is integrated by integrator 345. The integrated signal can be sampled and held by sample and hold module 350, and then converted to a digital signal by analog to digital converter (ADC) 355. This digital signal is used by processor 360 to generate a control signal V_{c} via digital to analogue converter (DAC) 365. A signal generator, which in this example is a direct digital synthesizer (DDS) 370, generates a modulation signal V_{mod}, as well as control signals for the amplifier 340, integrator 345, sample and hold module 350 and ADC 355. The control signal V_{c} and modulation signal V_{mod} are input into current source 315. The resultant output current from current source 315 is used as the drive current for the laser 310.

The FBG sensor in this embodiment is a πFBG sensor, and therefore reference is made to the transmission band. As already mentioned, the description equally applies to FBG sensors having a narrow reflection band, in which case any reference to the transmission band should be read as referring to the reflection band.

For lasers which do not exhibit mode hopping, the relation between the laser's output wavelength and its drive current is fairly linear, at least for a particular drive current range. Consequently the laser output wavelength can be controlled with sufficient accuracy by control of its drive current, which allows use of such lasers in closed loop systems.

The laser 310 is driven by a drive current which is output from current source 315, which is AC modulated by modulation signal V_{mod}. A DC current output from current source 315 should be set at a value such that the output center wavelength of the laser 310 matches the Bragg wavelength of the FBG 325, as a result of it being tuned using the control voltage Vc. The modulation signal V_{mod} is such that the laser's output wavelength is scanned across a major part of the transmission peak of the FBG 325 during a measurement period.

The laser's output radiation is sensed by FBG sensor 320, and its output current converted to a voltage by transimpedance amplifier 335. Amplifier 340 can selectively apply an amplification of +1 or -1, and is controlled to apply +1 amplification on one half of the signal and -1 amplification on the other half of the signal. Of course, it should be noted that the magnitude of the gain of amplifier 340 is unimportant; what matters is that amplifier 340 inverts only one part, e.g., one half, of its input signal, and does not invert the other part, e.g., other half. As the modulation signal V_{mod} is provided (in this example) by a direct digital synthesizer 370 the switching from +1 to -1 amplification can be very accurately related to the modulation signal V_{mod} via a control signal output by direct digital synthesizer 370. The signal output from amplifier 340 is then integrated by integrator 345 which integrates both halves of the input signal. The integrator 345 is reset synchronously with the modulation signal V_{mod} via a control signal from the DDS 370. The output of the integrator 345 is an error value V₀ which depends on the difference between the output center wavelength of the laser 310 and the Bragg wavelength of the FBG 325. Assuming that the output center wavelength of the laser 310 has been corrected to correspond with the Bragg wavelength of the FBG 325 in a previous measurement cycle, this error value V₀ corresponds to the change in the Bragg wavelength of the FBG 325 since correction. Consequently the desired strain and/or temperature values can be derived from this error signal V₀. Error value V₀ can be stored by means of sample and hold module 350 just prior to resetting the integrator 345 for the next measurement period. The sampled error signal can then be converted by ADC 355.

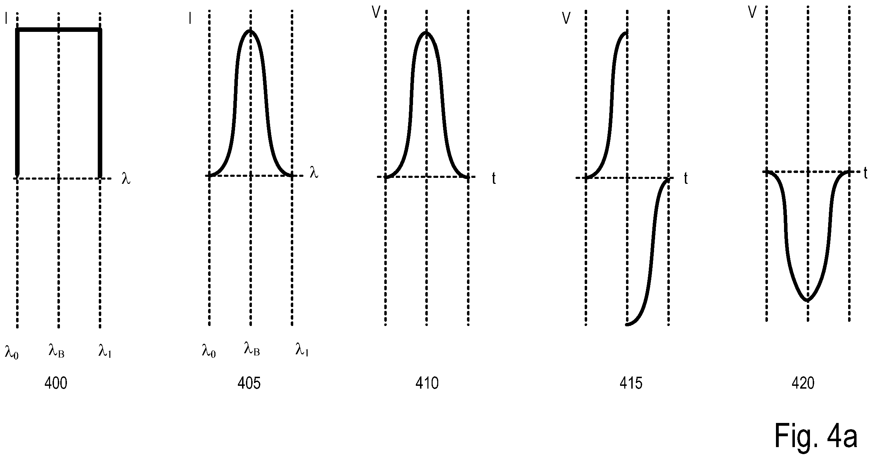

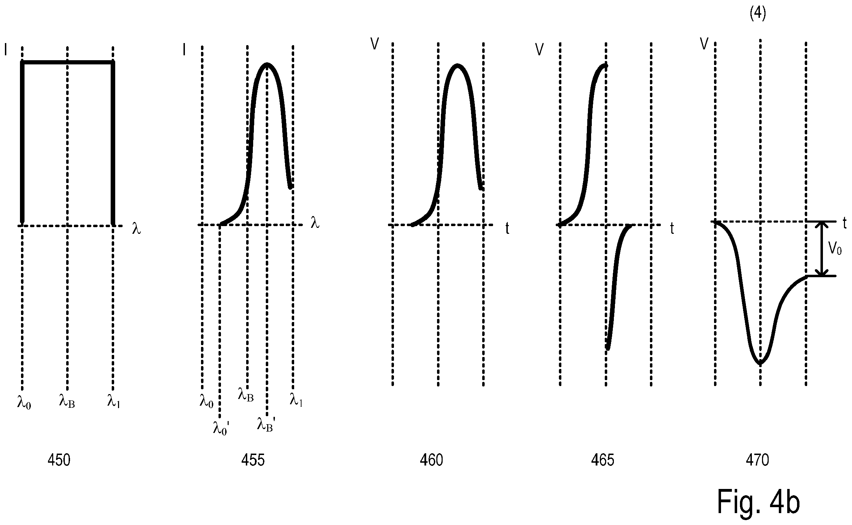

Figures 4a and 4b shows graphs to aid understanding of the operation of the monitoring apparatus shown in Figure 3. Figure 4a illustrates the situation where the laser output center wavelength is aligned with a value representing the Bragg wavelength of the FBG 325. Figure 4b illustrates the situation where the laser output center wavelength is not aligned with a value representing the Bragg wavelength of the FBG 325, due to a shift in this Bragg wavelength.

In Figure 4a, graph 400 shows the laser 310 output. Graph 405 is the FBG 325 output. Graphs 400 and 405 are plots of intensity I against wavelength λ. Graphs 410, 415 and 420 show respectively the output of transimpedance amplifier 335, the output of amplifier 340 and the output of integrator 345. Each of graphs 410, 415 and 420 is a plot of voltage V against time t. Similarly in Figure 4b, graph 450 shows the laser 310 output. Graph 455 is the FBG 325 output. Graphs 450 and 455 are plots of intensity I against wavelength λ. Graphs 460, 465 and 470 show respectively the output of transimpedance amplifier 335, the output of amplifier 340 and the output of integrator 345. Each of graphs 460, 465 and 470 is a plot of voltage V against time t.

Graph 400 shows that the output of the laser 310 is scanned between wavelengths λ₀ and λ₁ and centered upon wavelength λ_{B}. In this example, the laser 310 output is correctly tuned to the correct value such that wavelength λ_{B} is the Bragg wavelength of FBG 325. So the value correctly represents the Bragg wavelength. λ₀ And λ₁ are the limits of the transmission band of FBG 325.

Graph 405 shows that, as a consequence of the laser 310 output being correctly tuned, the output of the FBG sensor 330 is symmetrical and centered on the measurement window. This assumes that the output power of the laser 310 is constant and the transmission peak of the FBG 325 is symmetrical. Graph 410 shows the output of transimpedance amplifier, which is a time varying voltage having a similar shape to the transmission spectrum of graph 405. Graph 415 shows the output of amplifier 340, which separates the two halves of the signal, inverting one of the halves. As the two halves of the signal are the same but shifted either side of the x axis, the signal level following integration is zero, as is shown by graph 420. This indicates that there is no shift in the Bragg wavelength of the FBG 325 and no change in strain or temperature is detected. As a consequence there is no requirement for feedback correction to the drive current of laser 310 and the control signal V_{c} is zero.

In Figure 4b, the Bragg wavelength has shifted from λ_{B} to λ_{B}', and consequently the limits of the transmission band λ₀, λ₁ have shifted to λ₀', λ₁' (the latter wavelength being off the graph and not shown). The output of laser 310 has its center frequency and scanning range determined from a previously derived value for the Bragg wavelength, and so in this example is centered on wavelength λ_{B}, and scanned between limits λ₀, λ₁, as shown in graph 450. Graph 455 shows the effect of this on the transmission spectrum output from FBG 325. This transmission spectrum is no longer symmetrical or centered within the measurement window. The previously derived value does not properly represent the Bragg wavelength. Consequently the output of transimpedance amplifier 335 (graph 460) is also not symmetrical within the measurement window. As before amplifier 340 separates the two halves of the signal, inverting one of the halves (graph 465). However, now the two halves of the signal are not the same but shifted. As a result, the integrated signal (graph 470) shows a signal offset value V₀. The shift in the Bragg wavelength of the FBG 325 can be derived from the integrated signal. The shift in the Bragg wavelength can be derived from the signal offset value V₀, and from this shift, the change in strain or temperature of the object/component being sensed can be derived. Processor 360 can also determine a control signal V_{c} to tune the laser 310 output to the Bragg wavelength of the FBG sensor 330 for the next measurement period.

The main inaccuracies in the feedback loop which controls laser 310 will be caused by the timing jitter of the DDS 370 and the sensitivity of laser 310, as the integrator 345 time constant will only influence the open loop gain of the circuit and not the frequency response. Consequently the stability of this type of setup is generally very high. This stability can be improved by configuring the DDS 370 to generate the signals with integer step values and/or by controlling the laser temperature.

The advantages of this approach are:
- The linearity of the control is determined by the linearity of the laser 310.
- There are no MZIs used and consequently there is no need to measure the optical path.
- The wavelength stability is determined by the stability of the laser which is much better than the stability of an MZI.
- The integrator 345 will average both wavelength and amplitude noise of the laser.
- The signal sampled at the integrator 345 is the error signal for the control loop and as a consequence the error actual value is available directly after sampling (laser drive current + error signal is proportional to the actual value of the Bragg wavelength measured).
- The solution is scalable in the sense that if a higher resolution is required, a narrower FBG or a more stable laser can be used.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A monitoring apparatus configured to monitor a change in a property, comprising:
a fiber-Bragg grating sensor (320) operable to sense a band of wavelengths of incident radiation and to output a corresponding sensor output signal, the band of radiation being centered upon a first value representing a Bragg wavelength of the fiber-Bragg grating sensor;
an amplifier (335) arranged to separate the sensor output signal in a first part and a second part, to create an inverted first part by inverting the first part, and to create an amplified signal based on the inverted first part and the second part;
an integrator (345) operable to integrate the amplified signal to obtain an integrated signal; and
a processor (360) operable to:
derive a second value representative of a shift of the Bragg wavelength based on the integrated signal; and
derive a change in the monitored property from the second value.

2. A monitoring apparatus as claimed in claim 1, wherein the first part is a first half of the sensor output signal, and wherein the second part is a second half of the sensor output signal.

3. A monitoring apparatus as claimed in claim 1 or 2, wherein the processor is operable to derive the second value based on a signal offset value of the integrated signal.

4. A monitoring apparatus as claimed in claim 1, 2 or 3 being operable to control the output wavelength of a radiation source arranged to supply the band of wavelengths of incident radiation such that the output wavelength is scanned through the band of wavelengths of incident radiation during a measurement period.

5. A monitoring apparatus as claimed in claim 4 being operable to use the second value in a feedback loop to derive a corresponding control signal for controlling the output wavelength of the radiation source such that a center wavelength of the band of wavelengths is substantially aligned with the Bragg wavelength.

6. A monitoring apparatus as claimed in claim 5 wherein the radiation source is a laser and said control signal is used to adjust a drive current of said laser.

7. A monitoring apparatus as claimed in claim 6 comprising a signal generator to generate a modulation signal for modulating the drive current of said laser such that the laser output is scanned through said band of wavelengths.

8. A monitoring apparatus as claimed in claim 7 wherein said signal generator is a direct digital synthesizer and is operable to send control signals to the amplifier and the integrator to coordinate their operation.

9. A monitoring apparatus as claimed in any preceding claim wherein said change in property being monitored is strain and/or temperature.

10. A lithographic apparatus comprising the monitoring apparatus as claimed in any preceding claim.

11. A lithographic apparatus as claimed in claim 10 comprising a support structure and a substrate table, wherein the support structure is constructed to support a patterning device, the patterning device being capable of imparting a radiation beam with a pattern in its cross-section to form a patterned radiation beam, wherein the substrate table is constructed to hold a substrate, and wherein the monitoring apparatuses is operable to monitor a property of at least one of the support structure and the substrate table.

12. A method of monitoring a change in a property, comprising:
using a fiber-Bragg grating sensor to sense a band of wavelengths of incident radiation and to output a corresponding sensor output signal, said band of radiation being centered upon a first value representing a Bragg wavelength of the fiber-Bragg grating sensor;
separating the sensor output signal in a first part and a second part;
creating an inverted first part by inverting the first part;
creating an amplified signal based on the inverted first part and the second part;
integrating the amplified signal to obtain an integrated signal;
deriving a second value representative of a shift of the Bragg wavelength based on the integrated signal; and
deriving a change in the monitored property from the second value.

13. A method as claimed in claim 12, wherein the first part is a first half of the sensor output signal, and wherein the second part is a second half of the sensor output signal.

14. A method as claimed in claim 12 or 13 comprising controlling an output wavelength of a radiation source supplying the band of wavelengths of incident radiation such that said output wavelength is scanned through the band of wavelengths during a measurement period.

15. A method as claimed in any of claims 12 to 14 comprising wherein said change in property being monitored is strain and/or temperature.

## Patentansprüche

1. Eine Überwachungsvorrichtung, die konfiguriert ist, eine Änderung einer Eigenschaft zu überwachen, und Folgendes beinhaltet:
einen Faser-Bragg-Gittersensor (320), der betriebsfähig ist, ein Band von Wellenlängen eintreffender Strahlung abzufühlen und ein entsprechendes Sensorausgabesignal auszugeben, wobei das Band von Strahlung auf einen ersten Wert zentriert ist, der eine Bragg-Wellenlänge des Faser-Bragg-Gittersensors darstellt;
einen Verstärker (335), der eingerichtet ist, das Sensorausgabesignal in einen ersten Teil und einen zweiten Teil zu trennen, durch das Invertieren des ersten Teils einen invertierten ersten Teil zu erzeugen und auf der Basis des invertierten ersten Teils und des zweiten Teils ein verstärktes Signal zu erzeugen;
einen Integrator (345), der betriebsfähig ist, das verstärkte Signal zu integrieren, um ein integriertes Signal zu erhalten; und
einen Prozessor (360), der betriebsfähig ist zum:
Ableiten eines für eine Verschiebung der Bragg-Wellenlänge repräsentativen zweiten Werts auf der Basis des integrierten Signals; und
Ableiten einer Änderung der überwachten Eigenschaft aus dem zweiten Wert.

2. Überwachungsvorrichtung gemäß Anspruch 1, wobei der erste Teil eine erste Hälfte des Sensorausgabesignals ist und wobei der zweite Teil eine zweite Hälfte des Sensorausgabesignals ist.

3. Überwachungsvorrichtung gemäß Anspruch 1 oder 2, wobei der Prozessor betriebsfähig ist, den zweiten Wert auf der Basis eines Signalversatzwertes des integrierten Signals abzuleiten.

4. Überwachungsvorrichtung gemäß Anspruch 1, 2 oder 3, die betriebsfähig ist, die Ausgabewellenlänge einer Strahlungsquelle zu steuern, welche eingerichtet ist, das Band von Wellenlängen eintreffender Strahlung bereitzustellen, sodass die Ausgabewellenlänge während eines Messungszeitraums das Band von Wellenlängen eintreffender Strahlung überstreicht.

5. Überwachungsvorrichtung gemäß Anspruch 4, die betriebsfähig ist, den zweiten Wert in einer Rückkopplungsschleife zu verwenden, um ein entsprechendes Steuersignal zum Steuern der Ausgabewellenlänge der Strahlungsquelle abzuleiten, sodass eine mittlere Wellenlänge des Bands von Wellenlängen im Wesentlichen mit der Bragg-Wellenlänge übereinstimmt.

6. Überwachungsvorrichtung gemäß Anspruch 5, wobei die Strahlungsquelle ein Laser ist und das Steuersignal verwendet wird, um einen Ansteuerungsstrom des Lasers anzupassen.

7. Überwachungsvorrichtung gemäß Anspruch 6, die einen Signalgenerator zum Generieren eines Modulationssignals zum Modulieren des Ansteuerungsstroms des Lasers beinhaltet, sodass die Laserausgabe das Band von Wellenlängen überstreicht.

8. Überwachungsvorrichtung gemäß Anspruch 7, wobei der Signalgenerator ein direkter digitaler Synthesizer ist und betriebsfähig ist, an den Verstärker und den Integrator Steuersignale zum Koordinieren ihres Betriebs zu senden.

9. Überwachungsvorrichtung gemäß einem der vorhergehenden Ansprüche, wobei die überwachte Änderung der Eigenschaft Verformung und/oder Temperatur ist.

10. Eine lithographische Vorrichtung, die die Überwachungsvorrichtung gemäß einem der vorhergehenden Ansprüche beinhaltet.

11. Lithographische Vorrichtung gemäß Anspruch 10, die eine Stützstruktur und einen Substrattisch beinhaltet, wobei die Stützstruktur konstruiert ist, eine Musteraufbringungseinrichtung zu stützen, wobei die Musteraufbringungseinrichtung in der Lage ist, einen Strahlungsstrahl in seinem Querschnitt mit einem Muster zu versehen, um einen gemusterten Strahlungsstrahl zu bilden, wobei der Substrattisch konstruiert ist, um ein Substrat zu halten, und wobei die Überwachungsvorrichtung betriebsfähig ist, eine Eigenschaft von mindestens einem von der Stützstruktur und dem Substrattisch zu überwachen.

12. Ein Verfahren zum Überwachen einer Änderung einer Eigenschaft, das Folgendes beinhaltet:
Verwenden eines Faser-Bragg-Gittersensors, um ein Band von Wellenlängen eintreffender Strahlung abzufühlen und ein entsprechendes Sensorausgabesignal auszugeben, wobei das Band von Strahlung auf einen ersten Wert zentriert ist, der eine Bragg-Wellenlänge des Faser-Bragg-Gittersensors darstellt;
Trennen des Sensorausgabesignals in einen ersten Teil und einen zweiten Teil;
Erzeugen eines invertierten ersten Teils durch Invertieren des ersten Teils;
Erzeugen eines verstärkten Signals auf der Basis des invertierten ersten Teils und des zweiten Teils;
Integrieren des verstärkten Signals, um ein integriertes Signal zu erhalten;
Ableiten eines für eine Verschiebung der Bragg-Wellenlänge repräsentativen zweiten Werts auf der Basis des integrierten Signals; und
Ableiten einer Änderung der überwachten Eigenschaft aus dem zweiten Wert.

13. Verfahren gemäß Anspruch 12, wobei der erste Teil eine erste Hälfte des Sensorausgabesignals ist und wobei der zweite Teil eine zweite Hälfte des Sensorausgabesignals ist.

14. Verfahren gemäß Anspruch 12 oder 13, das das Steuern einer Ausgabewellenlänge einer Strahlungsquelle beinhaltet, welche das Band von Wellenlängen eintreffender Strahlung bereitstellt, sodass die Ausgabewellenlänge während eines Messungszeitraums das Band von Wellenlängen überstreicht.

15. Verfahren gemäß einem der Ansprüche 12 bis 14, beinhaltend wobei die überwachte Änderung der Eigenschaft Verformung und/oder Temperatur ist.

## Revendications

1. Un appareil de surveillance configuré afin de surveiller un changement dans une propriété, comprenant :
un capteur à réseau de Bragg sur fibre (320) opérationnel afin de capter une bande de longueurs d'onde de rayonnement incident et afin de sortir un signal de sortie de capteur correspondant, la bande de rayonnement étant centrée sur une première valeur représentant une longueur d'onde de Bragg du capteur à réseau de Bragg sur fibre ;
un amplificateur (335) agencé afin de décomposer le signal de sortie de capteur en une première partie et une deuxième partie, de créer une première partie inversée en inversant la première partie, et de créer un signal amplifié sur la base de la première partie inversée et de la deuxième partie ;
un intégrateur (345) opérationnel afin d'intégrer le signal amplifié pour obtenir un signal intégré ; et
un processeur (360) opérationnel afin :
de dériver une deuxième valeur représentative d'un décalage de la longueur d'onde de Bragg sur la base du signal intégré ; et
de dériver un changement dans la propriété surveillée d'après la deuxième valeur.

2. Un appareil de surveillance tel que revendiqué dans la revendication 1, dans lequel la première partie est une première moitié du signal de sortie de capteur, et dans lequel la deuxième partie est une deuxième moitié du signal de sortie de capteur.

3. Un appareil de surveillance tel que revendiqué dans la revendication 1 ou la revendication 2, dans lequel le processeur est opérationnel afin de dériver la deuxième valeur sur la base d'une valeur de déport de signal du signal intégré.

4. Un appareil de surveillance tel que revendiqué dans la revendication 1, la revendication 2 ou la revendication 3, lequel est opérationnel afin de contrôler la longueur d'onde de sortie d'une source de rayonnement agencée pour fournir la bande de longueurs d'onde de rayonnement incident de telle sorte que la longueur d'onde de sortie est amenée à balayer toute la bande de longueurs d'onde de rayonnement incident au cours d'une période de mesure.

5. Un appareil de surveillance tel que revendiqué dans la revendication 4, lequel est opérationnel afin d'utiliser la deuxième valeur dans une boucle d'asservissement pour dériver un signal de contrôle correspondant pour contrôler la longueur d'onde de sortie de la source de rayonnement de telle sorte qu'une longueur d'onde centrale de la bande de longueurs d'onde est substantiellement alignée avec la longueur d'onde de Bragg.

6. Un appareil de surveillance tel que revendiqué dans la revendication 5 dans lequel la source de rayonnement est un laser et ledit signal de contrôle est utilisé pour ajuster un courant d'attaque dudit laser.

7. Un appareil de surveillance tel que revendiqué dans la revendication 6 comprenant un générateur de signal afin de générer un signal de modulation pour moduler le courant d'attaque dudit laser de telle sorte que la sortie de laser est amenée à balayer toute ladite bande de longueurs d'onde.

8. Un appareil de surveillance tel que revendiqué dans la revendication 7 dans lequel ledit générateur de signal est un synthétiseur numérique direct et est opérationnel afin d'envoyer des signaux de contrôle à l'amplificateur et à l'intégrateur pour coordonner leur fonctionnement.

9. Un appareil de surveillance tel que revendiqué dans n'importe quelle revendication précédente dans lequel ledit changement dans la propriété qui est surveillé est la déformation et/ou la température.

10. Un appareil lithographique comprenant l'appareil de surveillance tel que revendiqué dans n'importe quelle revendication précédente.

11. Un appareil lithographique tel que revendiqué dans la revendication 10 comprenant une structure formant support et une table porte-substrat, dans lequel la structure formant support est construite afin de supporter un dispositif servant à conformer selon un motif, le dispositif servant à conformer selon un motif étant capable de conférer à un faisceau de rayonnement un motif dans sa coupe transversale afin de former un faisceau de rayonnement à motif, dans lequel la table porte-substrat est construite afin de porter un substrat, et dans lequel l'appareil de surveillance est opérationnel afin de surveiller une propriété d'au moins un élément parmi la structure formant support et la table porte-substrat.

12. Un procédé pour surveiller un changement dans une propriété, comprenant le fait :
d'utiliser un capteur à réseau de Bragg sur fibre pour capter une bande de longueurs d'onde de rayonnement incident et pour sortir un signal de sortie de capteur correspondant, ladite bande de rayonnement étant centrée sur une première valeur représentant une longueur d'onde de Bragg du capteur à réseau de Bragg sur fibre ;
de décomposer le signal de sortie de capteur en une première partie et une deuxième partie ;
de créer une première partie inversée en inversant la première partie ;
de créer un signal amplifié sur la base de la première partie inversée et de la deuxième partie ;
d'intégrer le signal amplifié pour obtenir un signal intégré ;
de dériver une deuxième valeur représentative d'un décalage de la longueur d'onde de Bragg sur la base du signal intégré ; et
de dériver un changement dans la propriété surveillée d'après la deuxième valeur.

13. Un procédé tel que revendiqué dans la revendication 12, dans lequel la première partie est une première moitié du signal de sortie de capteur, et dans lequel la deuxième partie est une deuxième moitié du signal de sortie de capteur.

14. Un procédé tel que revendiqué dans la revendication 12 ou la revendication 13 comprenant le fait de contrôler une longueur d'onde de sortie d'une source de rayonnement fournissant la bande de longueurs d'onde de rayonnement incident de telle sorte que ladite longueur d'onde de sortie est amenée à balayer toute la bande de longueurs d'onde au cours d'une période de mesure.

15. Un procédé tel que revendiqué dans n'importe lesquelles des revendications 12 à 14 comprenant dans lequel ledit changement dans la propriété qui est surveillé est la déformation et/ou la température.
